# EUROPEAN PATENT APPLICATION

(11) **EP 4 838 238 A1**
(43) Date of publication of application: **11.11.2026**
(21) Application number: 25854511.0
(22) Date of filing: 02.07.2025
(51) Int. Cl.: G01R 31/367, G01R 31/36, G01R 31/382, G01R 31/396, H02J 7/00, B60L 58/12

(54) **ELECTRONIC DEVICE AND BATTERY PERFORMANCE EVALUATION METHOD THEREFOR**

(30) Priority: 14.08.2024 KR 20240109368
(71) Applicant: LG Energy Solution, Ltd., Seoul 07335 (KR)
(72) Inventor: KIM, Kangsan, Daejeon 34122 (KR); SEO, Bo Kyung, Daejeon 34122 (KR)
(74) Representative: Plasseraud IP
(86) International application number: PCT/KR2025/009457
(87) International publication number: WO 2026/038698

(57) **Abstract**

An electronic device according to an embodiment of the present disclosure comprises a communication circuit and a processor operatively coupled to the communication circuit, wherein the processor may: acquire, by using the communication circuit, charging data of a plurality of batteries respectively located in a plurality of vehicles; generate, on the basis of the charging data of the plurality of batteries, feature data representing feature values related to required charging current amounts according to states of charge (SOC) of the plurality of batteries; acquire, by using the communication circuit, charging data of a target battery located in a target vehicle; extract, on the basis of the charging data of the target battery, a feature value related to a required charging current amount according to an SOC of the target battery; correct the feature value of the target battery on the basis of the feature data; and evaluate the performance of the target battery on the basis of the corrected feature value of the target battery.

## Description

### Technical Field

The present disclosure claims the benefit based on Korean Patent Application No. 10-2024-0109368 filed on August 14, 2024, which is incorporated herein by reference in its entirety.

Example embodiments of the present disclosure relate to an electronic apparatus and an evaluating battery performance method thereof.

### Background Art

Recent years have seen active research and development in the field of secondary batteries. Here, the secondary battery refers to a rechargeable battery, including both conventional Ni/Cd batteries and Ni/MH batteries, as well as recent lithium-ion batteries. Among rechargeable batteries, the lithium-ion battery has an advantage of much higher energy density compared to the conventional Ni/Cd batteries and Ni/MH batteries. In addition, the lithium-ion battery may be produced to be compact and lightweight to be used for a power supply of portable devices, and as the usage has been widened to a power supply of an electric vehicle, the lithium-ion battery is in the limelight as a next generation energy storage medium.

As the usage of rechargeable batteries increases, the technology for a management system to efficiently use and manage rechargeable batteries has also been increasing. Particularly, the management system needs to evaluate performance of rechargeable batteries to properly adjust charging or discharging power and capacity utilization strategy.

Generally, state of health (SOH) is used as a performance evaluation index of rechargeable batteries. As capacity of an exact value at state of charge (SOC) and begin of life (BOL) is required to calculate SOH of rechargeable batteries, specifications of rechargeable batteries should be considered. However, as specifications of rechargeable batteries are defined values in a fixed environment, deviation may be generated during manufacturing process and in a field, which leads to a problem of difficulty in evaluating exact performance.

Therefore, it is required to find a battery performance index having a consistent trend in a field environment.

### Detailed Description of the Invention

### Technical Goals

According to an example embodiment of the present disclosure, there is provided an electronic apparatus that may correct a feature value of a target battery that is a subject to performance evaluation by using feature data extracted from charging data of a plurality of vehicles and evaluate performance of the target battery based on the corrected feature value, and a method of evaluating battery performance thereof.

Technical goals to be achieved by the example embodiments of the present disclosure are not limited to technical goals described above, and other technical goals may be inferred from example embodiments below.

### Technical solutions

An electronic apparatus according to an example embodiment of the present disclosure, may include a communication circuit and a processor functionally connected to the communication circuit. The processor, by using the communication circuit, may obtain charging data of a plurality of batteries disposed in a plurality of vehicles, based on the charging data of the plurality of batteries, generate feature data indicating a feature value associated with a required charging current based on state of charge (SOC) of the plurality of batteries, by using the communication circuit, obtain charging data of a target battery disposed in a target vehicle, based on the charging data of the target battery, extract a feature value associated with a required charging current based on SOC of the target battery, based on the feature data, correct the feature value of the target battery, and, based on the feature value of the target battery that is corrected, evaluate performance of the target battery.

In the electronic apparatus according to an example embodiment of the present disclosure, the feature data may indicate the feature value of the plurality of batteries within a designated SOC range.

In the electronic apparatus according to an example embodiment of the present disclosure, the processor, based on the charging data of the plurality of batteries, may generate distribution data associated with a required charging current based on SOC in a designated charging condition. The distribution data may indicate a required charging current to increase SOC by a unit at a predetermined SOC. The processor may generate average distribution data by calculating an average value of a required charging current corresponding to each SOC in the distribution data, and based on the average distribution data, set the designated SOC range.

In the electronic apparatus according to an example embodiment of the present disclosure, the average distribution data may include a plurality of average distribution data classified based on a driving distance of a vehicle. The processor may set the designated SOC range by comparing the plurality of average distribution data to each other.

In the electronic apparatus according to an example embodiment of the present disclosure, the feature value may be an average value of a required charging current based on SOC within the designated SOC range of a predetermined battery.

In the electronic apparatus according to an example embodiment of the present disclosure, the feature data may include a plurality of trend data indicating a trend of the feature value changing based on a driving distance of a vehicle in a plurality of charging conditions.

In the electronic apparatus according to an example embodiment of the present disclosure, the processor, based on a linear regression algorithm, may generate trend data indicating a trend of the feature value changing based on a driving distance of a vehicle in a predetermined charging condition with a slope and Y-axis intercept value on a graph.

In the electronic apparatus according to an example embodiment of the present disclosure, the plurality of charging conditions may be distinguished from each other based on at least one of charging start SOC, charging end SOC, battery temperature during charging, and charging rate (C-rate).

In the electronic apparatus according to an example embodiment of the present disclosure, the processor may identify a target charging condition corresponding to the charging data of the target battery, identify target trend data corresponding to the target charging condition among the plurality of trend data, based on the target trend data, identify a driving distance of a vehicle corresponding to the feature value of the target battery, identify a standard feature value corresponding to the driving distance that is identified in pre-set standard trend data, and based on the standard feature value, correct the feature value of the target battery.

In the electronic apparatus according to an example embodiment of the present disclosure, the processor may calculate a performance score of the target battery by dividing the feature value of the target battery that is corrected by a feature value at begin of life (BOL) of the target battery.

In the electronic apparatus according to an example embodiment of the present disclosure, the processor may evaluate performance of the target battery by comparing the performance score of the target battery to a threshold score.

A method of evaluating performance of a battery performed by an electronic device according to an example embodiment of the present disclosure may include obtaining charging data of a plurality of batteries disposed in a plurality of vehicles, based on the charging data of the plurality of batteries, generating feature data indicating a feature value associated with a required charging current based on state of charge (SOC) of the plurality of batteries, obtaining charging data of a target battery disposed in a target vehicle, based on the charging data of the target battery, extracting a feature value associated with a required charging current based on SOC of the target battery, based on the feature data, correcting the feature value of the target battery, and based on the feature value of the target battery that is corrected, evaluating performance of the target battery.

In the method of evaluating performance of a battery performed by an electronic device according to an example embodiment of the present disclosure, the feature data may indicate the feature value of the plurality of batteries within a designated SOC range, and based on the charging data of the plurality of batteries, the method further including generating distribution data associated with a required charging current based on SOC in a designated charging condition, in which the distribution data indicates a required charging current to increase SOC by a unit at a predetermined SOC, generating average distribution data by calculating an average value of required charging currents corresponding to each SOC in the distribution data, and based on the average distribution data, setting the designated SOC range.

In the method of evaluating performance of a battery performed by an electronic device according to an example embodiment of the present disclosure, the feature data may include a plurality of trend data indicating a trend of the feature value changing based on a driving distance of a vehicle in a plurality of charging conditions. The correcting of the feature value of the target battery may include identifying a target charging condition corresponding to the charging data of the target battery, identifying target trend data corresponding to the target charging condition among the plurality of trend data, based on the target trend data, identifying a driving distance of a vehicle corresponding to the feature value of the target battery, identifying a standard feature value corresponding to the driving distance that is identified in pre-set standard trend data, and based on the feature value, correcting the feature value of the target battery.

In the method of evaluating performance of a battery performed by an electronic device according to an example embodiment of the present disclosure, the evaluating of performance of the target battery may include calculating a performance score of the target battery by dividing the feature value of the target battery that is corrected by a feature value at BOL of the target battery.

### Effects of the Invention

According to example embodiments of the present disclosure, it is possible to estimate a state of a battery and evaluate performance based on battery usage even without past usage history and unique information of a battery.

According to example embodiments of the present disclosure, it is possible to improve accuracy of performance evaluation of a battery by correcting a feature value of a target battery through feature data extracted from charging data obtained from a plurality of vehicles.

Effects of the present disclosure are not limited to the aforementioned effects, and other effects not mentioned will be clearly understood by those skilled in the art from the description of the claims.

### Brief Description of Drawings

FIG. 1 is a block diagram of an electronic apparatus according to an example embodiment of the present disclosure.
FIGS. 2A and 2B are diagrams to illustrate an example of an electronic apparatus according to an example embodiment of the present disclosure generating distribution data and average distribution data based on charging data of a plurality of batteries.
FIGS. 3A and 3B are diagrams to illustrate an example of an electronic apparatus according to an example embodiment of the present disclosure setting a designated SOC range based on a plurality of average distribution data classified based on a driving distance of a vehicle.
FIG. 4 is a diagram to illustrate an example of an electronic apparatus according to an example embodiment of the present disclosure generating a plurality of trend data.
FIG. 5 is a diagram to illustrate an example of an electronic apparatus according to an example embodiment of the present disclosure correcting a feature value of a target battery.
FIG. 6 is a diagram to illustrate an example of an electronic apparatus according to an example embodiment of the present disclosure calculating a performance score of a target battery.
FIG. 7 is a flowchart of an operation of an electronic apparatus according to an example embodiment of the present disclosure.
FIG. 8 is a flowchart of an operation of an electronic apparatus according to an example embodiment of the present disclosure.
FIG. 9 is a flowchart of an operation of an electronic apparatus according to an example embodiment of the present disclosure.

### Mode for Carrying Out the Invention

In describing the example embodiments, descriptions of technical contents that are well known in the art to which the present disclosure belongs and are not directly related to the present specification will be omitted. This is to more clearly communicate without obscure the subject matter of the present specification by omitting unnecessary description.

For the same reason, in the accompanying drawings, some components are exaggerated, omitted or schematically illustrated. In addition, the size of each component does not fully reflect the actual size. The same or corresponding components in each drawing are given the same reference numerals.

Advantages and features of the present disclosure and methods of achieving them will be apparent from the following example embodiments that will be described in more detail with reference to the accompanying drawings. It should be noted, however, that the present disclosure is not limited to the following example embodiments, and may be implemented in various forms. Accordingly, the example embodiments are provided only to disclose the present disclosure and let those skilled in the art know the category of the present disclosure. In the drawings, embodiments of the present disclosure are not limited to the specific examples provided herein and are exaggerated for clarity. The same reference numerals or the same reference designators denote the same elements throughout the specification.

At this point, it will be understood that each block of the flowchart illustrations and combinations of flowchart illustrations may be performed by computer program instructions. Since these computer program instructions may be mounted on a processor of a general purpose computer, special purpose computer, or other programmable data processing equipment, those instructions executed through the computer or the processor of other programmable data processing equipment may create a means to perform the functions be described in flowchart block(s). These computer program instructions may be stored in a computer usable or computer readable memory that can be directed to a computer or other programmable data processing equipment to implement functionality in a particular manner, and thus the instructions stored in the computer usable or computer readable memory may also be used to produce an article of manufacture containing instruction means for performing the functions described in the flowchart block(s). Computer program instructions may also be mounted on a computer or other programmable data processing equipment, such that a series of operating steps may be performed on the computer or other programmable data processing equipment to create a computer-implemented process to create a computer or other programmable data. Instructions for performing the processing equipment may also provide steps for performing the functions described in the flowchart block(s).

In addition, each block may represent a portion of a module, segment, or code that includes one or more executable instructions for executing a specified logical function(s). It should also be noted that in some alternative implementations, the functions noted in the blocks may occur out of order. For example, the two blocks shown in succession may in fact be executed substantially concurrently, or the blocks may sometimes be executed in the reverse order, depending on the corresponding function.

At this point, the term "unit" may refer to a software or a hardware element such as a field-programmable gate array (FPGA) or an application-specific integrated circuit (ASIC), and a "unit" may perform predetermined roles. However, the "unit" is not limited to software or hardware. A "unit" may be configured to be in an addressable storage medium or to regenerate one or more processors. Accordingly, as an example, a "unit" may include software elements, object-oriented software elements, elements such as class elements and task elements, processes, functions, properties, procedures, subroutines, segments of program code, drivers, firmware, microcode, a circuit, data, a database, data structures, tables, arrays, and variables. A function provided within elements and "units" may be combined into a smaller number of elements and "units", or separated further into additional elements and "units". In addition, components and "units" may be implemented to regenerate one or more CPUs within a device or a secure multimedia card.

The expression "at least one of A, B, and C" may indicate the following meaning including: A alone; B alone; C alone; both A and B together; both A and C together; both B and C together; or all three of A, B, and C together.

In the present disclosure, a "terminal" may be implemented as a computer or a portable terminal capable of accessing a server or another terminal through a network. Here, the computer may include, for example, a laptop computer, a desktop computer, and a notebook equipped with a web browser. The portable terminal may be a wireless communication device ensuring a portability and a mobility, and include any type of handheld wireless communication device, for example, a tablet PC, a smartphone, a communication-based terminal such as international mobile telecommunication (IMT), code division multiple access (CDMA), W-code division multiple access (W-CDMA), and long term evolution (LTE).

In the following description, example embodiments of the present disclosure will be described in detail with reference to the drawings so that those skilled in the art can easily carry out the present disclosure. The present disclosure may be embodied in many different forms and is not limited to the example embodiments described herein.

Hereinafter, example embodiments of the present disclosure will be described with reference to the drawings.

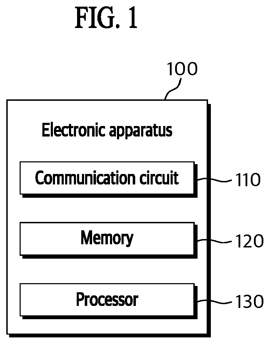

FIG. 1 is a block diagram of an electronic apparatus 100 according to an example embodiment of the present disclosure.

Referring to FIG. 1, the electronic apparatus 100 may include a communication circuit 110, a memory 120, and a processor 130. According to an example embodiment, the electronic apparatus 100 may further include at least one element (for example, a display, an input device, or an output device) in addition to the elements illustrated in FIG. 1.

According to an example embodiment, the electronic apparatus 100 may be implemented as at least one of a notebook, a desktop, a laptop, and a server computing device receiving battery data from an external electronic apparatus (for example, a vehicle) and handling the battery data.

According to an example embodiment, the communication circuit 110 may establish a wired communication channel and/or a wireless communication channel between the electronic apparatus 100 and the external electronic apparatus, and transmit and receive data to and from the external electronic apparatus through the established communication channel. According to an example embodiment, the communication circuit 110 may receive battery charging data from the external electronic apparatus and/or an external server.

Here, communication, in other words, data transmission and reception may be carried out via a wired channel or a wireless channel. To this end, the communication circuit 110 may include a wired communication module that connects to the Internet through local area network (LAN), a mobile communication module that connects to a mobile communication network through a mobile communication base station to transmit and receive data, a short-range communication module that uses communication methods of wireless local area network (WLAN) such as Wi-Fi, or wireless personal area network (WPAN) such as Bluetooth and Zigbee, and a satellite communication module that uses global navigation satellite system (GNSS) such as global positioning system (GPS), and a combination thereof.

According to an example embodiment, the memory 120 may include a volatile memory and/or a non-volatile memory.

According to an example embodiment, the memory 120 may store data used by at least one element (for example, the processor 130). For example, data may include software (or, an instruction associated with the software), input data, or output data. According to an example embodiment, when executed by the processor 130, an instruction may allow the electronic apparatus 100 to perform operations defined by the instruction.

According to an example embodiment, the processor 130 may be embodied as a computer or a similar device depending on hardware, software, or a combination thereof. Hardware-wise, the processor 130 may be embodied as a form of an electronic circuit performing a control function by processing an electrical signal, and software-wise, embodied as a form of a program operating a hardware processor 130. According to an example embodiment, the processor 130 may be functionally connected to an element (for example, the communication circuit 110 and/or the memory 120) included in the electronic apparatus 100 and control a connected element.

According to an example embodiment, the processor 130 may include a central processing unit (CPU), an application processor, a graphics processing unit (GPU), a neural processing unit (NPU), an image signal processor (ISP), a sensor hub processor, and a communication processor.

Meanwhile, if description below does not specifically mention, it may be construed that an operation of the electronic apparatus 100 is performed by a control of the processor 130.

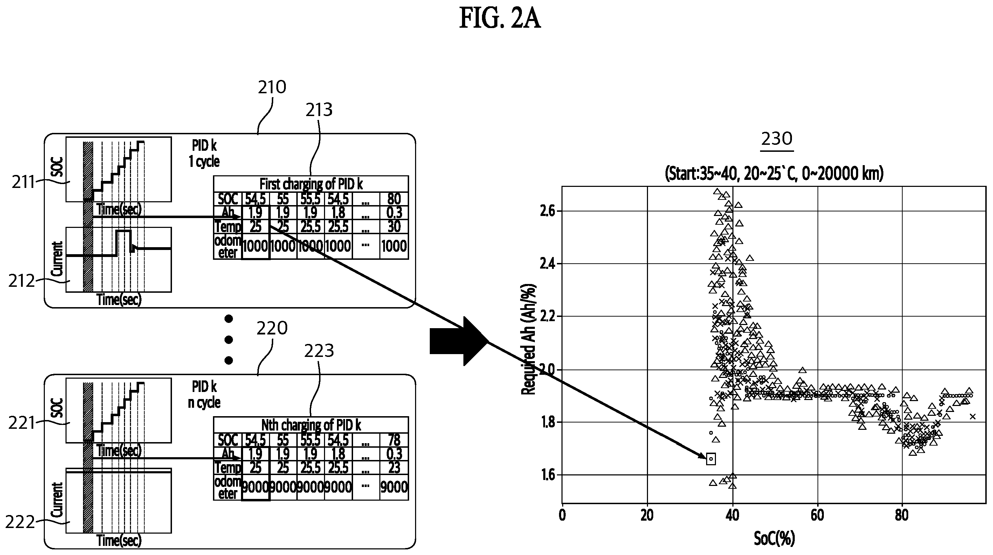

Hereinafter, a method of the electronic apparatus 100 evaluating performance of a battery will be described with reference to FIGS. 2A, 2B, 3A, 3B, 4, 5, and 6.

According to an example embodiment, the electronic apparatus 100 may obtain charging data of a plurality of batteries disposed in a plurality of vehicles. Here, the plurality of batteries may correspond one-to-one with the plurality of vehicles, and the plurality of vehicles may be of the same type.

According to an example embodiment, the electronic apparatus 100 may generate feature data indicating a feature value associated with a required charging current based on state of charge (SOC) of the plurality of batteries based on charging data of the plurality of batteries. Here, the feature value may be an average value of a required charging current based on the SOC within a designated SOC range. In addition, the required charging current may be for a required charging current to increase SOC by a unit (for example, 1%) at a predetermined SOC.

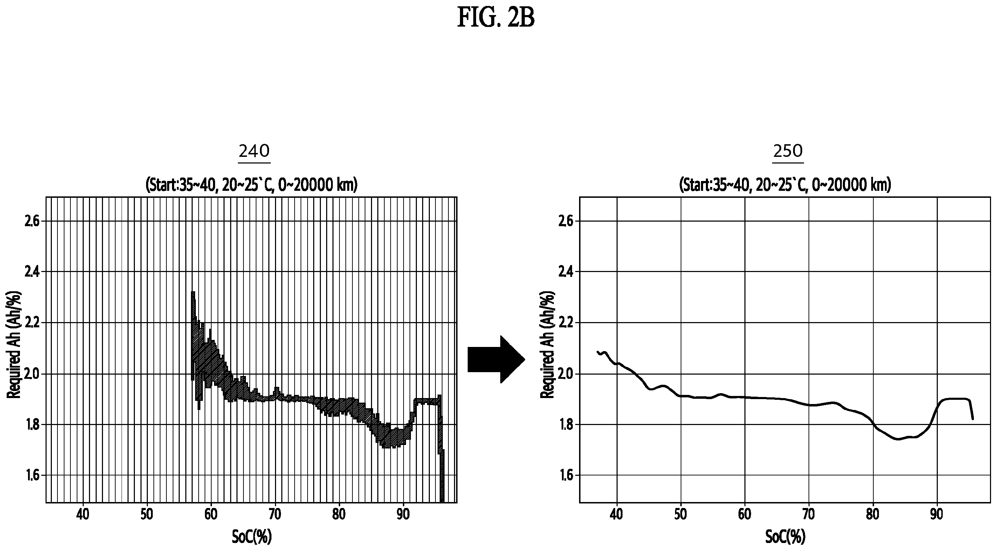

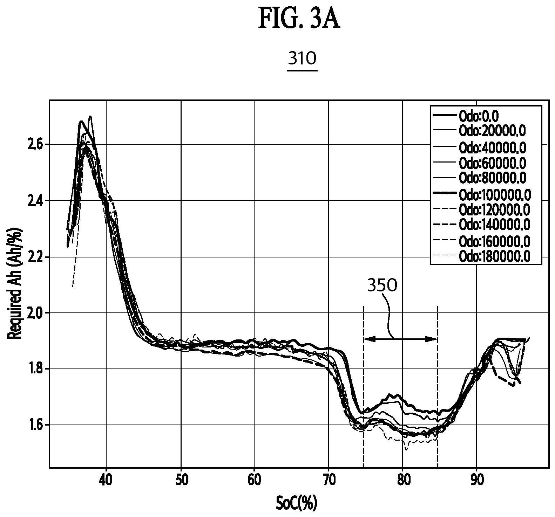

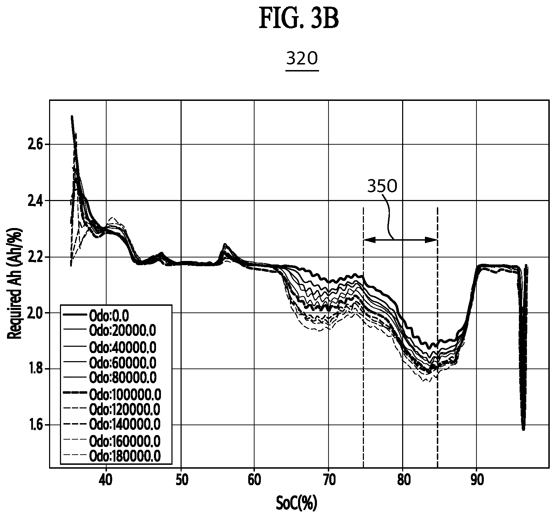

According to an example embodiment, the feature data may indicate the feature value of the plurality of batteries within the designated SOC range. Hereinafter, a method of the electronic apparatus 100 setting the designated SOC range will be described with reference to FIGS. 2A, 2B, 3A, and 3B.

FIGS. 2A and 2B are diagrams to illustrate an example of the electronic apparatus 100 according to an example embodiment of the present disclosure generating distribution data and average distribution data based on charging data of a plurality of batteries.

Referring to FIG. 2A, the electronic apparatus 100 may generate a heat map 230 based on charging data 210 and 220 of a plurality of batteries.

According to an example embodiment, the electronic apparatus 100 may obtain the charging data 210 and 220 of the plurality of batteries disposed in a plurality of vehicles. Here, the charging data 210 and 220 of the plurality of batteries may include time series charging data 211, 212, 221, and 222 and matching data 213 and 223. The charging data 210 and 220 of FIG. 2A may only illustrate charging data per charging cycle of a predetermined battery (for example, Pack ID k (PID k)), but is not limited thereto, and the charging data 210 and 220 described later may include charging data per charging cycle of the plurality of batteries disposed in the plurality of vehicles.

According to an example embodiment, the electronic apparatus 100 may obtain the time series charging data 211, 212, 221, and 222 of the plurality of batteries from the plurality of vehicles. The time series charging data 211, 212, 221, and 222 may indicate a state value of a battery (for example, SOC, voltage, current, and temperature) over time during a battery charging. Each of the time series charging data 211, 212, 221, and 222 may correspond to a predetermined charging cycle of a predetermined battery.

According to an example embodiment, the electronic apparatus 100 may generate the matching data 213 and 223 based on the time series charging data 211, 212, 221, and 222 of the plurality of batteries and driving distance data of the plurality of vehicles. The electronic apparatus 100 may obtain the driving distance data corresponding to the time series charging data 211, 212, 221, and 222 from the plurality of vehicles by using the communication circuit 110. The matching data 213 and 223 may represent state values of a battery matched at each time point. For example, the electronic apparatus 100 may generate the matching data 213 by matching state values of a battery (for example, SOC, charging current, and temperature) at each time point and a driving distance of a vehicle based on the time series charging data 211 and 212 corresponding to a predetermined charging cycle of a predetermined battery.

According to an example embodiment, the electronic apparatus 100 may generate the heat map 230 that represents a required charging current based on SOC as a form of heat distribution based on the charging data 210 and 220 of a plurality of batteries. Here, the heat map 230 may distinguish and represent each plot based on battery temperature, and in the heat map 230, an X-axis may indicate battery SOC, and a Y-axis may indicate a required charging current to increase SOC by a unit (for example, 1%) at each SOC. In addition, the heat map 230 may correspond to a designated charging condition (for example, a start SOC is 35%-45%, and a battery temperature is 20°C-25°C) and a driving distance (for example, 0km-20000km).

Referring to FIG. 2B, the electronic apparatus 100 may generate distribution data 240 associated with a required charging current based on SOC in a designated charging condition based on the heat map 230 of FIG. 2A. For example, the electronic apparatus 100 may generate the distribution data 240 corresponding to the heat map 230 by removing noise included in the heat map 230. Here, the distribution data 240, unlike the heat map 230, may not distinguish and represent each plot based on battery temperature, and in the distribution data 240, an X-axis may indicate battery SOC, and a Y-axis may indicate a required charging current to increase SOC by a unit (for example, 1%) at each SOC. In addition, the distribution data 240 may represent two or more required charging currents corresponding to the same SOC.

According to an example embodiment, the electronic apparatus 100 may generate average distribution data 250 based on the distribution data 240. For example, the electronic apparatus 100 may generate the average distribution data 250 by calculating an average value of a required charging current corresponding to each SOC in the distribution data 240. Here, in the average distribution data 250, an X-axis may indicate battery SOC, and a Y-axis may indicate a required charging current to increase SOC by a unit (for example, 1%) at each SOC.

The heat map 230, the distribution data 240, and the average distribution data 250 of FIGS. 2A and 2B may illustrate a required charging current in a predetermined charging condition (for example, a start SOC is 35% to 40%, and a battery temperature is 20°C to 25°C) and within a designated driving distance range (for example, 0 to 20000km), but is not limited thereto, and the electronic apparatus 100 may generate a heat map, distribution data, and average distribution data indicating a required charging current based on SOC in various charging conditions and within various driving distance ranges.

According to an example embodiment, the electronic apparatus 100 may set a designated SOC range based on the distribution data 250. For example, the electronic apparatus 100 may set the designated SOC range based on a plurality of average distribution data classified based on a driving distance of a vehicle.

FIGS. 3A and 3B are diagrams to illustrate an example of the electronic apparatus 100 according to an example embodiment of the present disclosure setting a designated SOC range based on a plurality of average distribution data classified based on a driving distance of a vehicle. More specifically, FIG. 3A may illustrate a plurality of average distribution data in a fast charging condition of a first charging rate, and FIG. 3B may illustrate a plurality of average distribution data in a normal charging condition of a second charging rate lower than the first charging rate.

Referring to FIG. 3A, a graph 310, illustrating a plurality of average distribution data based on a driving distance range of a vehicle (for example, 0km-20000km, 20000km-40000km, and 40000km-60000km) in the fast charging condition of the first charging rate, may be identified. The plurality of average distribution data included in the graph 310 may be data distinguished and generated by the electronic apparatus 100 based on charging data of the plurality of batteries, distinguished by driving distance of a vehicle, as described in FIGS. 2A and 2B.

According to an example embodiment, the electronic apparatus 100 may set a designated SOC range by comparing the plurality of average distribution data included in the graph 310. For example, the electronic apparatus 100 may set an SOC range (for example, 75%-85%) 350 in which a difference between a minimum value and a maximum value of a required charging current of the plurality of average distribution data exceeds a threshold difference as a designated range.

Referring to FIG. 3B, a graph 320, illustrating a plurality of average distribution data based on a driving distance range of a vehicle (for example, 0km-20000km, 20000km-40000km, and 40000km-60000km) in a normal charging condition of the second charging rate, may be identified. The plurality of average distribution data included in the graph 320 may be data generated by the electronic apparatus 100 based on charging data of the plurality of batteries, distinguished by driving distance of a vehicle, as described in FIGS. 2A and 2B.

According to an example embodiment, the electronic apparatus 100 may set a designated SOC range by comparing the plurality of average distribution data included in the graph 320. For example, the electronic apparatus 100 may set an SOC range (for example, 65%-85%) in which a difference between a minimum value and a maximum value of a required charging current of the plurality of average distribution data exceeds a threshold difference as the designated SOC range. As another example, in consideration of the graph 310 in a fast charging condition of FIG. 3A together, the electronic apparatus 100 may set an SOC range (for example, 75%-85%) 350 in which a difference between a minimum value and a maximum value of a required charging current of the plurality of average distribution data exceeds a threshold difference as the designated SOC range.

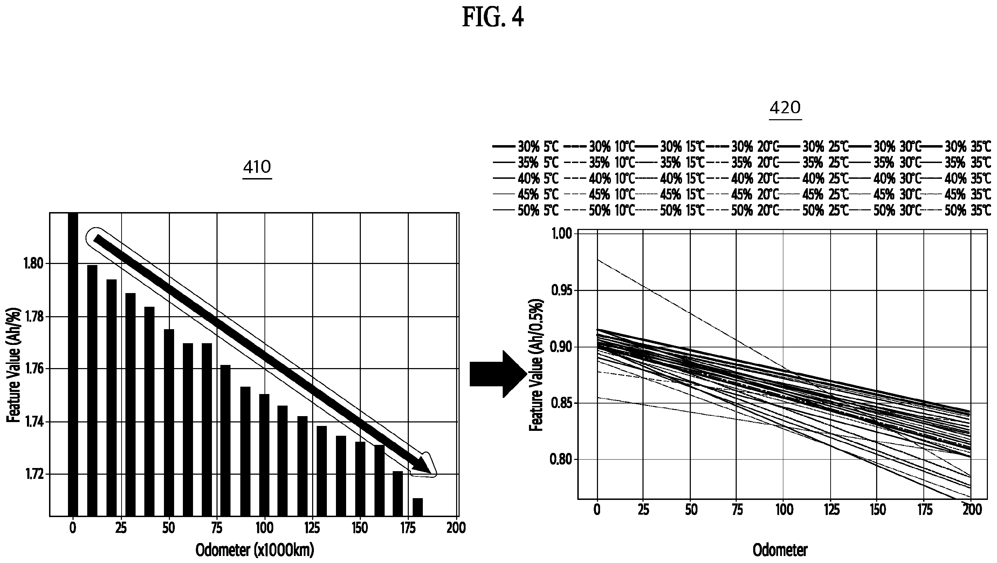

According to an example embodiment, feature data may include a plurality of trend data indicating a trend of a feature value changing based on a driving distance of a vehicle in a plurality of charging conditions. Here, the plurality of charging conditions may be distinguished from each other based on at least one of charging start SOC, charging end SOC, battery temperature during charging, and charging rate (C-rate). Hereinafter, a method of the electronic apparatus 100 generating the plurality of trend data will be described with reference to FIG. 4.

FIG. 4 is a diagram to illustrate an example of the electronic apparatus 100 according to an example embodiment of the present disclosure generating a plurality of trend data.

Referring to FIG. 4, the electronic apparatus 100 may generate a graph 420 indicating a plurality of trend data based on a graph 410 indicating a feature value based on a driving distance of a vehicle. Here, the graph 410 may correspond to one charging condition among a plurality of charging conditions. In other words, the electronic apparatus 100 may generate the graph 420 based on a plurality of graphs 410 that correspond to each of the plurality of charging conditions. In addition, in graphs 410 and 420, an X-axis may indicate a driving distance of a vehicle, and a Y-axis may indicate a feature value.

According to an example embodiment, the electronic apparatus 100 may generate a set of trend data from feature values of the graph 410 based on a linear regression algorithm. Here, trend data may represent a trend of a feature value changing based on a driving distance of a vehicle in a predetermined charging condition with a slope and a Y-intercept value on the graph 420. As described above, the electronic apparatus 100 may generate the plurality of trend data that correspond to each of the plurality of charging conditions.

According to an example embodiment, the electronic apparatus 100 may obtain charging data of a target battery disposed in a target vehicle. For example, the electronic apparatus 100 may obtain the charging data of the target battery from the target vehicle by using the communication circuit 110. Here, the target vehicle may be a vehicle of the same type as a plurality of vehicles transmitting the charging data used for generating feature data.

According to an example embodiment, the electronic apparatus 100 may extract a feature value of the target battery based on the charging data of the target battery. As described above, the feature value may be associated with a required charging current based on SOC of a battery. More specifically, the feature value may be an average value of a required charging current based on SOC within a designated SOC range.

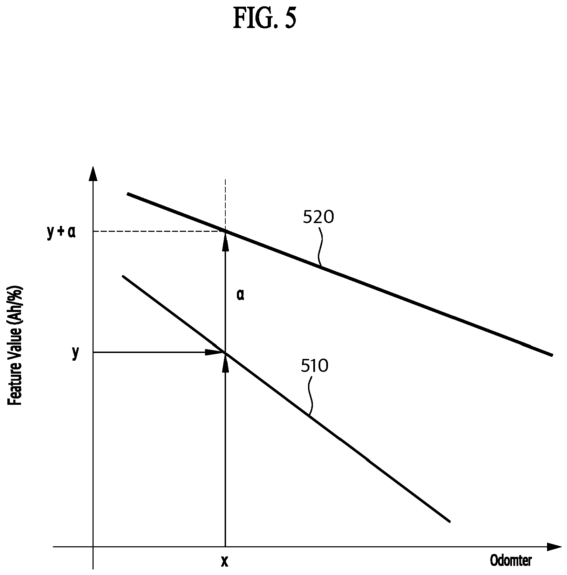

According to an example embodiment, the electronic apparatus 100 may correct the feature value of the target battery based on the feature data. For example, the feature data may include the plurality of trend data included in the graph 420 of FIG. 4. Hereinafter, a method of the electronic apparatus 100 correcting a feature value of a target battery will be described with reference to FIG. 5.

FIG. 5 is a diagram to illustrate an example of the electronic apparatus 100 according to an example embodiment of the present disclosure correcting a feature value of a target battery.

Referring to FIG. 5, a graph 500, illustrating target trend data 510 and standard trend data 520, may be identified. In the graph 500, an X-axis may indicate a driving distance of a vehicle, and a Y-axis

According to an example embodiment, the electronic apparatus 100 may identify a target charging condition corresponding to charging data of a target battery. For example, the target charging condition may be associated with at least one of charging start SOC, charging end SOC, battery temperature during charging, and charging rate (C-rate).

According to an example embodiment, the electronic apparatus 100 may identify the target trend data 510 corresponding to the target charging condition among a plurality of trend data included in feature data. The electronic apparatus 100 may identify a driving distance x of a vehicle corresponding to a feature value y of a target battery based on the target trend data 510.

According to an example embodiment, the electronic apparatus 100 may identify a standard feature value y+α corresponding to the driving distance x that is identified in the pre-set standard trend data 520. Here, the standard trend data 520 may be identical to one of the plurality of trend data included in the feature data. According to an example embodiment, the standard trend data 520 may be data that is pre-set by an operator and stored in the memory 120. According to another example embodiment, the electronic apparatus 100 may set the standard trend data 520 based on the target charging condition of the target battery. For example, when a temperature of the target battery during charging exceeds a designated value, predetermined trend data whose Y-axis value is higher than the target trend data 510 among the plurality of trend data included in the feature data may be set as standard trend data. As another example, when a temperature of the target battery during charging is less than the designated value, predetermined trend data whose Y-axis value is lower than the target trend data 510 among the plurality of trend data included in the feature data may be set as standard trend data.

According to an example embodiment, the electronic apparatus 100 may correct the feature value y of the target battery based on the standard feature value y+α. For example, the electronic apparatus 100 may correct the feature value y of a battery to the feature value y+α based on a correction value α.

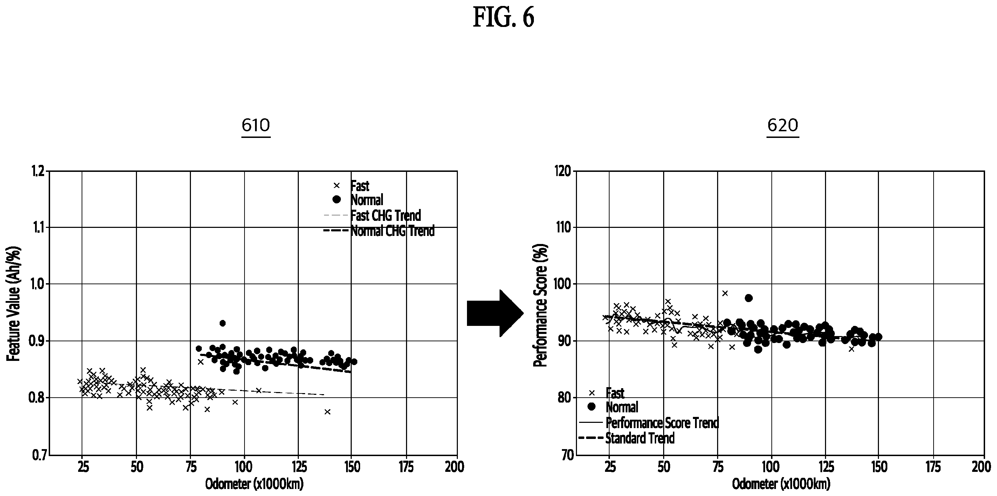

According to an example embodiment, the electronic apparatus 100 may evaluate performance of the target battery based on the corrected feature value of the target battery. The electronic apparatus 100 may calculate a performance score of the target battery and evaluate performance of the target battery based on the calculated performance score. Hereinafter, a method of the electronic apparatus 100 calculating a performance score of the target battery will be described with reference to FIG. 6.

FIG. 6 is a diagram illustrating an example of the electronic apparatus 100 according to an example embodiment of the present disclosure calculating a performance score of a target battery.

Referring to FIG. 6, the electronic apparatus 100 may generate data 620 indicating the performance score of the target battery based on data 610 indicating a feature value of a target battery in a fast charging condition and a normal charging condition.

According to an example embodiment, the electronic apparatus 100 may calculate the performance score of the target battery by dividing a corrected feature value of the target battery by a feature value at the begin of life (BOL) of the target battery. Here, the feature value at the BOL of the target battery may be a value that is pre-set and stored in the memory 120.

More specifically, the electronic apparatus 100 may calculate the performance score of the target battery based on an equation 1 below.
[Equation 1] $Performance Score \left[%\right] = 100 \times \frac{{Feature}_{corrected} \left[Ah/%\right]}{{Feature}_{BOL} \left[Ah/%\right]}$

In the equation 1, Feature_{corrected} may be the corrected feature value of the target battery, and Feature_{BOL} may be the feature value at the BOL of the target battery.

According to an example embodiment, the electronic apparatus 100 may evaluate performance of the target battery by comparing the performance score of the target battery to a threshold score. For example, when the performance score of the target battery exceeds the threshold score, the electronic apparatus 100 may evaluate the target battery as a normal battery. As another example, when the performance score of the target battery is less than the threshold score, the electronic apparatus 100 may evaluate the target battery as an abnormal battery.

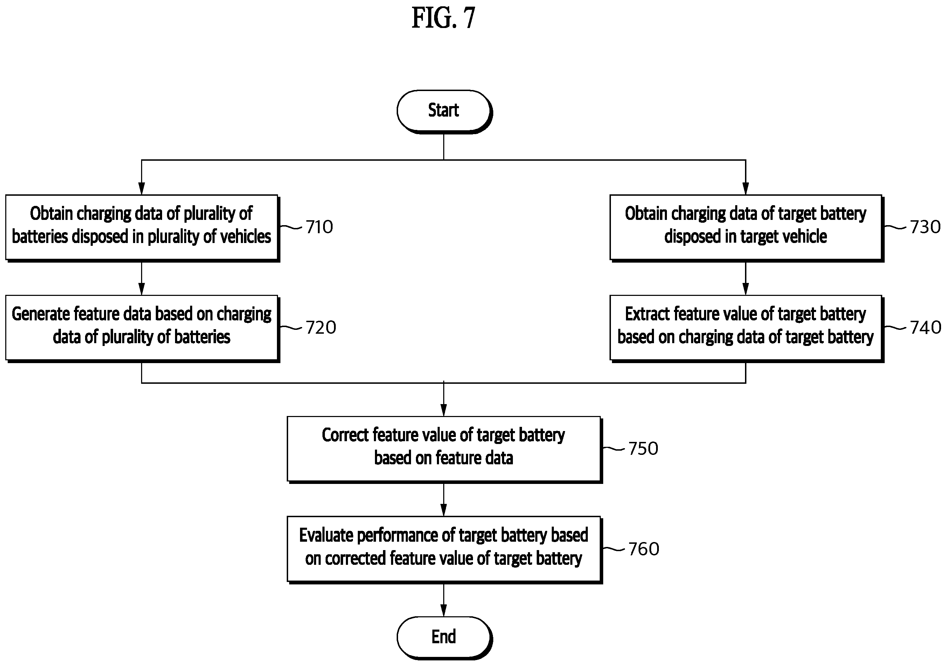

FIG. 7 is a flowchart of an operation of an electronic apparatus according to an example embodiment of the present disclosure. As an operation method of FIG. 7 may be performed by the electronic apparatus 100 of FIG. 1, description overlapping with the aforementioned content will be omitted, and the operation method of FIG. 7 may be described using configurations of FIG. 1.

An example embodiment illustrated in FIG. 7 is merely an example embodiment, and the sequence of operation according to various example embodiments of the present disclosure may be different from what is described in FIG. 7, and some operations illustrated in FIG. 7 may be omitted, or the sequence of operations may be changed, or operations may be combined.

Referring to FIG. 7, in operation 710, the electronic apparatus 100 may obtain charging data of a plurality of batteries disposed in a plurality of vehicles. Here, the plurality of batteries may correspond one-to-one with the plurality of vehicles, and the plurality of vehicles may be of the same type.

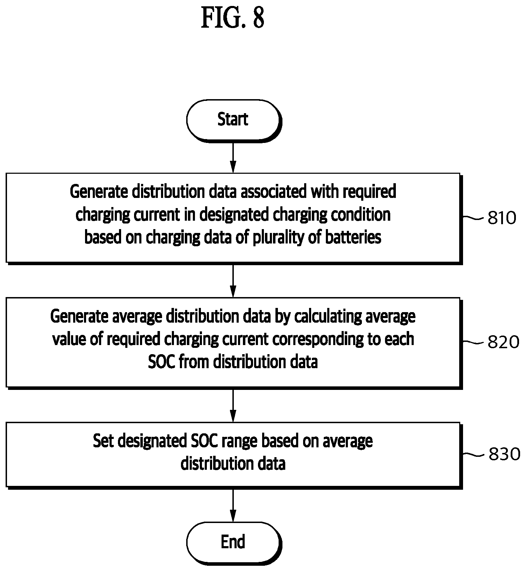

In operation 720, the electronic apparatus 100 may generate feature data based on charging data of the plurality of batteries obtained in operation 710. Here, the feature data may indicate a feature value associated with a required charging current based on SOC of the plurality of batteries. In addition, the feature value may be an average value of a required charging current based on SOC within a designated SOC range. Operation 720 in which electronic apparatus 100 generates the feature data may be described more specifically through FIG. 8 described later.

In operation 730, the electronic apparatus 100 may obtain charging data of a target battery disposed in a target vehicle. Here, the target vehicle may be a vehicle of the same type as a plurality of vehicles transmitting the charging data used for generating the feature data.

In operation 740, the electronic apparatus 100 may extract a feature value of the target battery based on the charging data of the target battery obtained in operation 730.

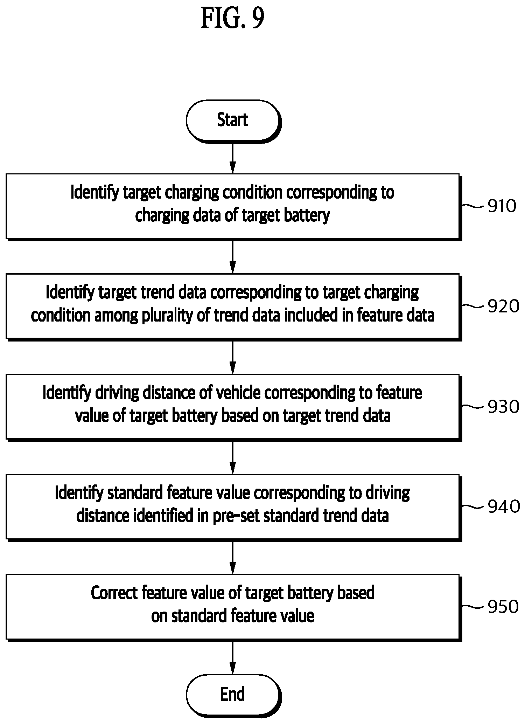

In operation 750, the electronic apparatus 100 may correct the feature value of the target battery extracted in operation 740 based on the feature data generated in operation 720. Operation 750 in which the electronic apparatus 100 corrects the feature value may be described more specifically through FIG. 9 described later.

In operation 760, the electronic apparatus 100 may evaluate performance of the target battery based on the feature value of the target battery corrected in operation 750. According to an example embodiment, the electronic apparatus 100 may calculate a performance score of the target battery and evaluate performance of the target battery based on the calculated performance score. According to an example embodiment, the electronic apparatus 100 may calculate the performance score of the target battery by dividing the corrected feature value of the target battery by a feature value at the begin of life (BOL) of the target battery.

FIG. 8 is a flowchart of an operation of an electronic apparatus according to an example embodiment of the present disclosure. As an operation method of FIG. 8 may be performed by the electronic apparatus 100 of FIG. 1, description overlapping with the aforementioned content will be omitted, and the operation method of FIG. 8 may be described using configurations of FIG. 1.

An example embodiment illustrated in FIG. 8 is merely an example embodiment, and the sequence of operation according to various example embodiments of the present disclosure may be different from what is described in FIG. 8, and some operations illustrated in FIG. 8 may be omitted, or the sequence of operations may be changed, or operations may be combined.

Referring to FIG. 8, in operation 810, the electronic apparatus 100 may generate distribution data associated with a required charging current in a designated charging condition based on the charging data of the plurality of batteries obtained in operation 710 of FIG. 7.

According to an example embodiment, the electronic apparatus 100 may generate a heat map representing a required charging current based on SOC as a form of heat distribution based on the charging data of the plurality of batteries.

According to an example embodiment, the electronic apparatus 100 may generate the distribution data associated with the required charging current based on SOC in the designated charging condition based on the heat map. For example, the electronic apparatus 100 may generate the distribution data corresponding to the heat map by removing noise included in the heat map. The distribution data may indicate two or more required charging currents corresponding to the same SOC.

In operation 820, the electronic apparatus 100 may calculate an average value of required charging currents corresponding to each SOC in the distribution data generated in operation 810 and generate average distribution data.

In operation 830, the electronic apparatus 100 may set a designated SOC range based on the average distribution data generated in operation 820.

According to an example embodiment, the electronic apparatus 100 may set a designated SOC range based on a plurality of average distribution data classified based on a driving distance of a vehicle. For example, the electronic apparatus 100 may set the designated SOC range by comparing the plurality of average distribution data to each other. The electronic apparatus 100 may set an SOC range in which a difference between a minimum value and a maximum value of a required charging current of the plurality of average distribution data exceeds a threshold difference as the designated SOC range.

FIG. 9 is a flowchart of an operation of an electronic apparatus according to an example embodiment of the present disclosure. As an operation method of FIG. 9 may be performed by the electronic apparatus 100 of FIG. 1, description overlapping with the aforementioned content will be omitted, and the operation method of FIG. 9 will be described using configurations of FIG. 1.

An example embodiment illustrated in FIG. 9 is merely an example embodiment, and the sequence of operation according to various example embodiments of the present disclosure may be different from what is described in FIG. 9, and some operations illustrated in FIG. 9 may be omitted, or the sequence of operations may be changed, or operations may be combined.

Referring to FIG. 9, in operation 910, the electronic apparatus 100 may identify a target charging condition corresponding to the charging data of the target battery obtained in operation 730 of FIG. 7. For example, the target charging condition may be associated with at least one of charging start SOC, charging end SOC, battery temperature during charging, and charging rate (C-rate).

In operation 920, the electronic apparatus 100 may identify target trend data corresponding to the target charging condition among a plurality of trend data included in the feature data generated in operation 720 of FIG. 7.

In operation 930, the electronic apparatus 100 may identify a driving distance of a vehicle corresponding to the feature value of the target battery extracted in operation 720 based on the target trend data identified in operation 920.

In operation 940, the electronic apparatus 100 may identify a standard feature value corresponding to the driving distance identified in operation 930 from pre-set standard trend data. Here, the standard trend data may be identical to one of the plurality of trend data included in the feature data generated in operation 720 of FIG. 7. According to an example embodiment, the standard trend data may be data pre-set by an operator and stored in the memory 120. According to another example embodiment, the electronic apparatus 100 may set the standard trend data based on the target charging condition of the target battery.

In operation 950, the electronic apparatus 100 may correct the feature value of the target battery extracted in operation 740 of FIG. 7 based on the standard feature value identified in operation 940.

The electronic apparatus in accordance with the above-described example embodiments may include a processor, a memory which stores and executes program data, a permanent storage such as a disk drive, a communication port for communication with an external device, and a user interface device such as a touch panel, a key, and an icon. Methods realized by software modules or algorithms may be stored in a computer-readable recording medium as computer-readable codes or program commands which may be executed by the processor. Here, the computer-readable recording medium may be a magnetic storage medium (for example, a read-only memory (ROM), a random-access memory (RAM), a floppy disk, or a hard disk) or an optical reading medium (for example, a CD-ROM or a digital versatile disc (DVD)). The computer-readable recording medium may be dispersed to computer systems connected by a network so that computer-readable codes may be stored and executed in a dispersion manner. The medium may be read by a computer, may be stored in a memory, and may be executed by the processor.

The present example embodiments may be represented by functional blocks and various processing steps. These functional blocks may be implemented by various numbers of hardware and/or software configurations that execute specific functions. For example, the present example embodiments may adopt direct circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as C, C++, Java, and assembler including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor, for example.

The above-described example embodiments are merely examples and other embodiments may be implemented within the scope of the following claims.

## Claims

1. An electronic apparatus, comprising:
a communication circuit; and
a processor functionally connected to the communication circuit, and wherein the processor,
by using the communication circuit, obtains charging data of a plurality of batteries disposed in a plurality of vehicles,
based on the charging data of the plurality of batteries, generates feature data indicating a feature value associated with a required charging current based on state of charge (SOC) of the plurality of batteries,
by using the communication circuit, obtains charging data of a target battery disposed in a target vehicle,
based on the charging data of the target battery, extracts a feature value associated with a required charging current based on SOC of the target battery,
based on the feature data, corrects the feature value of the target battery, and,
based on the feature value of the target battery that is corrected, evaluates performance of the target battery.

2. The electronic apparatus of claim 1,
wherein the feature data indicates the feature value of the plurality of batteries within a designated SOC range.

3. The electronic apparatus of claim 2,
wherein the processor,
based on the charging data of the plurality of batteries, generates distribution data associated with a required charging current based on SOC in a designated charging condition, wherein the distribution data indicates required charging currents to increase SOC by a unit at a predetermined SOC,
generates average distribution data by calculating an average value of required charging currents corresponding to each SOC in the distribution data, and
based on the average distribution data, sets the designated SOC range.

4. The electronic apparatus of claim 3,
wherein the average distribution data includes a plurality of average distribution data classified based on a driving distance of a vehicle, and wherein the processor sets the designated SOC range by comparing the plurality of average distribution data to each other.

5. The electronic apparatus of claim 2,
wherein the feature value is an average value of a required charging current based on SOC within the designated SOC range of a predetermined battery.

6. The electronic apparatus of claim 1,
wherein the feature data includes a plurality of trend data indicating a trend of the feature value changing based on a driving distance of a vehicle in a plurality of charging conditions.

7. The electronic apparatus of claim 6,
wherein the processor,
based on a linear regression algorithm, generates trend data indicating a trend of the feature value changing based on a driving distance of a vehicle in a predetermined charging condition with a slope and Y-axis intercept value on a graph.

8. The electronic apparatus of claim 6,
wherein the plurality of charging conditions are distinguished from each other based on at least one of charging start SOC, charging end SOC, battery temperature during charging, and charging rate (C-rate).

9. The electronic apparatus of claim 6,
wherein the processor
identifies a target charging condition corresponding to the charging data of the target battery,
identifies target trend data corresponding to the target charging condition among the plurality of trend data,
based on the target trend data, identifies a driving distance of a vehicle corresponding to the feature value of the target battery,
identifies a standard feature value corresponding to the driving distance that is identified in pre-set standard trend data, and
based on the standard feature value, corrects the feature value of the target battery.

10. The electronic apparatus of claim 1,
wherein the processor
calculates a performance score of the target battery by dividing the feature value of the target battery that is corrected by a feature value at begin of life (BOL) of the target battery.

11. The electronic apparatus of claim 10,
wherein the processor
evaluates performance of the target battery by comparing the performance score of the target battery to a threshold score.

12. A method of evaluating performance of a battery performed by an electronic apparatus, the method comprising:
obtaining charging data of a plurality of batteries disposed in a plurality of vehicles;
based on the charging data of the plurality of batteries, generating feature data indicating a feature value associated with a required charging current based on state of charge (SOC) of the plurality of batteries;
obtaining charging data of a target battery disposed in a target vehicle;
based on the charging data of the target battery, extracting a feature value associated with a required charging current based on SOC of the target battery;
based on the feature data, correcting the feature value of the target battery; and
based on the feature value of the target battery that is corrected, evaluating performance of the target battery.

13. The method of claim 12,
wherein the feature data indicates the feature value of the plurality of batteries within a designated SOC range, and
based on the charging data of the plurality of batteries, the method further comprising:
generating distribution data associated with a required charging current based on SOC in a designated charging condition, wherein the distribution data indicates a required charging current to increase SOC by a unit at a predetermined SOC;
generating average distribution data by calculating an average value of required charging currents corresponding to each SOC in the distribution data; and
based on the average distribution data, setting the designated SOC range.

14. The method of claim 12,
wherein the feature data includes a plurality of trend data indicating a trend of the feature value changing based on a driving distance of a vehicle in a plurality of charging conditions, and
wherein the correcting of the feature value of the target battery comprises:
identifying a target charging condition corresponding to the charging data of the target battery;
identifying target trend data corresponding to the target charging condition among the plurality of trend data;
based on the target trend data, identifying a driving distance of a vehicle corresponding to the feature value of the target battery;
identifying a standard feature value corresponding to the driving distance that is identified in pre-set standard trend data; and
based on the feature value, correcting the feature value of the target battery.

15. The method of claim 12,
wherein the evaluating of performance of the target battery includes calculating a performance score of the target battery by dividing the feature value of the target battery that is corrected by a feature value at begin of life (BOL) of the target battery.
